# EUROPEAN PATENT SPECIFICATION

(11) **EP 2 725 367 B1**
(45) Date of publication and mention of the grant of the patent: **15.04.2020**
(21) Application number: 12802182.1
(22) Date of filing: 21.06.2012
(51) Int. Cl.: G01R 31/08, H02H 1/00, G01R 31/11, G01R 19/175, G01R 31/12

(54) **METHOD AND DEVICE FOR MONITORING PARTIAL DISCHARGES**
VERFAHREN UND VORRICHTUNG ZUR ÜBERWACHUNG VON TEILENTLADUNGEN
PROCÉDÉ ET DISPOSITIF DE SURVEILLANCE DES DÉCHARGES PARTIELLES

(30) Priority: 21.06.2011 ES 201131043
(43) Date of publication of application: 30.04.2014
(73) Proprietor: Ormazabal Corporate Technology, A.I.E., 48340 Amorebieta-Etxano (Vizcaya) (ES)
(72) Inventor: LARRIETA ZUBIA, Javier, E-48340 Amorebieta-Etxano (Vizcaya) (ES); GILBERT, Ian, Paul, E-48340 Amorebieta-Etxano (Vizcaya) (ES); BADETZ, David, E-48340 Amorebieta-Etxano (Vizcaya) (ES); MULROY, Patrick, E-48340 Amorebieta-Etxano (Vizcaya) (ES); HURTADO VICUÑA, Aritz, E-48340 Amorebieta-Etxano (Vizcaya) (ES)
(74) Representative: Carpintero Lopez, Francisco
(86) International application number: PCT/ES2012/070459
(87) International publication number: WO 2012/175779

(56) References cited:
- EP-A1- 0 491 554
- EP-A1- 0 491 554
- EP-A2- 0 974 846
- EP-A2- 1 593 981
- DE-A1-102006 043 120
- ES-T3- 2 335 148
- US-A- 4 006 410
- US-A- 4 897 607
- US-B1- 6 297 642
- JOHN AUSTIN ET AL.: 'On-Line Digital Computer System for Measurement of Partial Discharges in Insulation Structures.' IEEE TRANSACTIONS ON ELECTRICAL INSULATION vol. EI-1, no. 4, 30 November 1976, pages 129 - 139, XP001605168
- LI JIANMING ET AL.: 'Intelligent partial discharge measurement device.' ELECTRICAL INSULATION, 1994., CONFERENCE RECORD OF THE 1994 IEEE INTER NATIONAL SYMPOSIUM ON 05 June 1994, PITTSBURGH, PA, USA, pages 162 - 165., XP010139442

## Description

### OBJECT OF THE INVENTION

The present invention is related to a method and device for monitoring partial discharges in distribution elements under voltage, online or offline, of a high voltage power distribution network.

### BACKGROUND OF THE INVENTION

A partial discharge is a dielectric breakdown phenomenon which is confined and located in the region of an insulating medium, between two conductors that are at different potential. In the majority of the cases, the phenomena of partial discharges are due to insulation faults in the distribution elements which form part of the power distribution network, and said distribution elements may consist for example of cables, transformers, switches, electrical connections, etc.

Partial discharges can be characterized into three types depending on the properties of the medium between the conductive parts. They can be external, also referred to as corona, that normally occur through the process of ionization of the air contained between the conductive parts, which is called corona effect when the phenomenon begins to be visible. They can also be superficial, produced on the contact surface of two different insulating materials, or they can be internal, produced in internal cavities of a solid dielectric material.

Partial discharges have harmful effects on the medium where they occur. In a solid or liquid medium they produce a slow but continuous degradation, which ends with the dielectric breakdown of the insulating medium. In a gaseous medium, such as for example air, the partial discharges produce the well-known corona effect, comprising consequences that can be directly perceived through sight, sound or smell. However, there are other consequences that are undetectable to the naked eye, such as the generation of heat, power losses, mechanical erosion of the surfaces that are ionically bombarded, interferences with the radio waves, etc.

If they occur and go unnoticed, they can have very serious consequences. If the problem remains unsolved, deterioration will take place until the distribution element is completely destroyed. The replacement or repair of the damaged distribution element can be very expensive and may involve a cut in supply of the distribution network for an extended period of time, as well as major economic losses for electricity companies. The key to preventing any possible problem is the detection and measurement of partial discharges. The measurement of partial discharges and their analysis can help prevent risks and suitably maintain the facilities. In short, carrying out a rigorous control can save a lot of time and money.

In accordance with the IEC 60270 standard, a partial discharge pulse is defined as a current or voltage pulse resulting from a partial discharge in the object of analysis. As a result, there are monitoring systems with different measurement methods that have been developed for measuring this phenomenon. In general, the measurement of partial discharges can be performed by means of online (keeping the distribution element, or part of the distribution network, in which the measurement will be performed, in service) or offline (rendering the distribution element, or part of the distribution network, in which the measurement will be performed, out of service) measurement methods. In this latter case, the distribution element or part of the distribution network to be analyzed must be rendered out of service (without network voltage) and energized for the analysis thereof by means of an external voltage source. In addition, as the distribution element must be out of service during the analysis period, the preparation of the distribution element is the main disadvantage that this measuring method comprises. The process is expensive and often complex, especially in production facilities, since in the majority of the cases, a reserve system is not easily available. Likewise, in some cases, as for example in the cables, the use of an offline method for measuring partial discharges implies that the analysis can only be carried out on a limited cable length.

On the contrary, in an online measurement method, the distribution element object of analysis can remain in service and be tested under the service voltage with the normal mechanical and thermal stresses. Therefore, no external voltage source is necessary, and in addition, as the distribution element remains under the service voltage, it is possible to perform a continuous measurement of partial discharges. Offline measurements of partial discharges are carried out with voltages 2-3 times higher than the service voltage, which increases the risk of causing this unwanted phenomenon in distribution elements which, under normal service conditions, would have continued operating for a long period. In contrast, by means of an online analysis, the distribution elements are not exposed to these types of additional risks.

By monitoring the partial discharges, in addition to measuring partial discharges, other functions can be performed which allow a continuous assessment of the status of the insulation to be carried out and the prevention of faults in the distribution elements, such as for example in the cables, as well as the prevention of economic losses for the electrical companies, service cuts involving long periods of waiting time for the consumer until the restoration of the network, etc. In this regard, there are solutions in which the partial discharge signals are discriminated with respect to electrical noise (due to electromagnetic interference, radio interference, communications, power electronic equipment, transient arcs between adjacent conductive parts, corona effects, harmonics in the network, etc.), the position of the partial discharges is located, the magnitude of the same is determined, the type of partial discharge is identified, the seriousness of the different sources of partial discharges is diagnosed, etc. In order to implement said functions, physical systems comprising sensors for capturing the signals to be measured, devices for registering the partial discharge signals, signal transmission means, information storage devices, numerical tools for processing the results, necessary protection elements, etc. are used.

The monitoring systems to date comprise certain limitations in terms of the execution of some of their functions, such as, for example, in the quantification of the magnitude of the partial discharges through measuring instruments. Currently, the use of a device or calibrator is known that generates and injects a partial discharge-type pulse of a known magnitude into the distribution network. This enables the calibration of the measuring instruments of the partial discharges, as well as the quantification of the partial discharges that may exist in the distribution network, by comparing the known magnitude of said pulse with the signal measured in the network. Calibration is understood as the set of operations that establish, under specific conditions, the relationship (scale factor) that exists between the values indicated by a measuring instrument and the corresponding known values of a measurement magnitude.

Therefore, devices or calibrators are used to carry out reliable measurements of partial discharges, which are directly coupled to the distribution element object of the test, and which continuously generate and inject known charge pulses during the calibration process, such that the measuring instrument of partial discharges detects said pulses. In this process it is important to determine the scale factor of the circuit for each of the measuring instruments according to the configuration of the distribution network, since both the pulses generated and injected by the calibrator and the pulses of existing partial discharges can be attenuated according to the capacity of the test distribution element, to the capacity of the coupling capacitor, to the frequency, to the topology of the distribution network, etc. The scale factor compensates for this attenuation and must be determined whenever there is any change in the network, such as for example in the case of a change in topology or configuration of the electric distribution network. The scale factor enables the quantification of the measurements obtained through the measuring instruments.

Patent ES2335148T3 can be mentioned as an example of the state of the art, which protects a device or calibrator for the generation of defined charge pulses that enable online measurements of partial discharges to be carried out, as well as the method for generating pulses and the partial discharge measurement system. This calibrator comprises a connection through which the defined charge pulses are injected into the distribution element object of the test, these pulses being generated continuously during the partial discharge measurement, and in turn, enabling the calibration of the partial discharge measuring instrument. Likewise, the calibrator comprises an outer electrode that defines parasitic capacitances to ground, said capacitances being used by the calibrator for the generation of the defined charge pulses that are injected into the distribution element object of the test. Moreover, the calibrator comprises a photodiode with which the synchronization of the injection is carried out through the detection of a light source powered by the voltage of the network. Therefore, the injection is carried out in synchronization with the voltage waveform of the network, but entails the drawback that the point or phase angle where the injection should be carried out is not specified within the voltage waveform, which entails the risk that the defined charge pulse can be injected at a phase angle of the voltage waveform comprising background noise, and therefore, said pulse might be attenuated or confused with that noise.

The existing monitoring systems entail a further drawback in terms of the location of the position of the partial discharges. Usually, for the location, at least two measuring instruments are used in different locations and periodic and synchronized captures are carried out. In order for the measuring instruments to perform synchronized captures, it is necessary for said instruments to start the capture of signals at the same time, for which reason it must emit an actuation or triggering order to said instruments, such as for example a pulse.

Some solutions use a synchronization pulse generator, intended to generate a synchronism pulse based on the cadence previously marked by a control and processing computer and coinciding with a zero crossing of the voltage, this pulse lastly being sent to the measuring instruments through a fiber optic cable. Likewise, the use of a zero crossing detector is necessary, which informs the synchronization pulse generator when the network voltage waveform of the monitored line crosses zero. This way of synchronizing the measuring instruments entails the drawback of needing to generate and emit an additional synchronization pulse, the use of additional means being necessary, such as for example a voltage zero crossing detector, a pulse generator, optical fiber cables, etc., which entails an increase of the cost of the facilities.

In other solutions the triggering or actuation signals of the measuring instruments are emitted via GPS, and in this case the coverage is a major problem, for example in underground facilities.

The article *"*On-line digital computer system for measurement of partial discharges in insulation structures" of IEEE Transactions on Electrical Insulation, vol. EI-11, NO. 4, December 1976 discloses a method for monitoring partial discharges in distribution elements in volt of a high voltage power distribution network in service. This method discloses the way to synchronize two or more measure equipments to instruct the order to start the measurement but does not disclose the synchronization of the injection of the charge pulses with the voltage of the network and because of that the defined charge pulses could be injected in a phase angle of the voltage waveform comprising background noise, etc., and therefore the measurements could be attenuated or confused with the background noise, etc.

The document EP0491554A1 discloses a method of initiating and monitoring partial discharges in an insulating medium. This method applies a relatively low frequency time varying exciting waveform to a sample of an insulating medium. Therefore the exciting waveform used is generated by an external source, supposing the problem of rendering out of service the sample of an insulating medium that is going to be tested or part of the distribution network in which the measurement will be carried out. Besides, said method supposes the problem that the analysis can be carried out only on a limited sample length in the case of cables for example.

The online measurement methods have the drawback that the distribution elements to be tested are in service, and therefore, under voltage, such that they are not accessible. In this regard, the devices or calibrators used in online measurement methods need a coupling point in the distribution network that does not entail the direct coupling on the distribution elements to be tested.

### SUMMARY OF THE INVENTION

The system for monitoring partial discharges in distribution elements under voltage, such as cables, transformers, switches, electrical connections, etc., of a high voltage power distribution network enables the monitoring of partial discharges both in distribution elements or parts of the online (in service) and offline (out of service) distribution network.

The high voltage distribution network comprises at least one facility, such as for example an electric power transformer substation or a distribution substation, provided with distribution elements. The monitoring system comprises at least one measuring instrument of partial discharges. At least one device for generating and injecting defined charge pulses is placed in the same facility as the measuring instrument or in a second facility provided with other instruments. If the distribution network is made up of three or more facilities, it is also possible to have a measuring instrument and a generation and injection device in the same facility and another measuring instrument and generation device in the other two facilities respectively. In this way, the monitoring system enables the quantification of the partial discharge measurements through the measuring instrument, as well as the synchronization of said measuring instrument in accordance with the features of claim 1, solving the problems or limitations that the systems existing at present comprise concerning the quantification of the measurements and the synchronization of the instruments. The same defined charge pulses generated and injected by the generation and injection device enables both the quantification of the measurements of the partial discharges and the synchronization of the measuring instruments for capturing the signals, avoiding the use of additional means such as for example GPS, optical fiber cables, synchronization pulse generators, voltage zero crossing detectors, etc.

Moreover, the monitoring system also enables the partial discharges coming from insulation faults of the network to be differentiated from other sources of partial discharges, locating (determining the distance between the point where the partial discharge occurs and the point where the measurement is carried out), identifying partial discharges, etc. In this regard, the signals captured by at least one measuring instrument are physically and mathematically processed through standard techniques that are not the object of the present invention and are stored in a database with the purpose of having a history for the subsequent assessment of the status of the insulation. Examples of standard techniques used include the application of the Wavelet Transform of the recorded signals and the statistical analysis of their components in order to find transient events characteristic of partial discharge pulses that are distinguished from the statistical evolution of the electrical noise, the application of the reflectometry technique to locate the partial discharges, automatic defect pattern recognition tools trained through a neural network in order to identify the type of partial discharge and emitting a diagnostic of the status of the insulation, etc. The system also enables the monitoring of the instantaneous voltage and current values and the effective values of the currents and voltages of each phase, as well as the homopolar currents and voltages, energies, power, etc.

This enables the monitoring of the high voltage distribution network and the management of at least one facility to be carried out both locally and remotely, management being understood as all those tasks that enable the optimization of the maintenance of the distribution network, determining when and where to carry out an intervention in order to prevent failures, service cuts rendering consumers without power supply and minimizing the costs for the electrical companies. To do so, different analyses, alarms, etc are carried out.

In relation to the quantification of the measurements of the partial discharges through the measuring instruments, in a first step the generation and injection device tracks the voltage of the distribution network determining the reference with respect to which the defined charge pulse is injected. The tracking of the voltage of the network enables the generation and injection device to inject, at different time intervals, at least one defined charge pulse regarding the zero crossing of the voltage of the same line phase where the generation and injection device is connected.

In a second step, by means of the generation and injection of a defined charge pulse and synchronized with the voltage of the network, the quantification of the measurements of the partial discharges through the measuring instrument is enabled, regardless of the configuration or topology of the distribution network.

Likewise, the monitoring system may comprise a calibration step of at least one measuring instrument arranged in at least one first distribution facility, determining for this purpose a scale factor of the circuit for the at least one measuring instrument according to the configuration of the electric distribution network. This scale factor enables the quantification of the magnitude of at least one partial discharge through the at least one measuring instrument.

In order to determine the scale factor, the device for generating and injecting defined charge pulses enables the injection, at different time intervals, of said pulses in synchronization with the voltage waveform of the network and in a phase angle determined by the user, preventing the risk that the defined charge pulse can be injected in a phase angle of the voltage waveform comprising background noise, real partial discharges, etc., and therefore preventing attenuations in the measurement of the defined charge pulse or confusion between said defined charge pulse and the background noise, real partial discharges, etc.

Likewise, by means of the injection of defined charge pulses at different time intervals, in synchronization with the voltage waveform of the network and in a phase angle determined by the user, the monitoring system enables a step corresponding to the synchronization of at least two measuring instrument to be carried out, determining the moment at which said measuring instruments, located in different locations, must start to measure the propagation times of the pulses between their generation point and the measurement point, and/or aligning the clocks of the measuring instruments. The alignment of the clocks ensures the accuracy of the measurements that are carried out with the measuring instruments. Then the time differential between two measurement points is calculated for the subsequent calculation of the distance between the point where the partial discharge occurs and the point where the measurement is carried out, thus locating the position of the partial discharge.

The synchronization of at least two measuring instruments comprises a first step in which, by means of at least one zero crossing counter of the network voltage, the measurement starting time of at least one measuring instrument is adjusted to the measurement starting time of at least another measuring instrument. The voltage zero crossing counter of the network may be integrated inside the measuring instrument.

Likewise, in a second synchronization step, the voltage waveform cycle of the network of at least one measuring instrument is adjusted with the voltage waveform cycle of the network of at least another measuring instrument, using to do so at least the defined charge pulse generated previously or at least one additional one generated and injected by the device for generating and injecting defined charge pulses.

By means of a third synchronization step, the phase angle of the voltage waveform of the network of at least one measuring instrument is adjusted with the phase angle of the voltage waveform of the network of at least another measuring instrument, using to do so the pulse or pulses generated previously by the device for generating and injecting defined charge pulses.

The measuring instruments of the monitoring system may consist of portable or stationary instruments and may be linked to communication means that are installed in at least one first distribution facility, such that said communication means are connected to a Remote Control Center, thus enabling both the monitoring of the high voltage distribution network and the management of at least one first distribution facility to be carried out remotely.

Therefore, the possibility that the execution of the different functions of the monitoring system can be carried out in the Control Center or in at least a first facility wherein the measuring instruments are located has been envisaged. In this regard, the identification of the partial discharges can be carried out in the Control Center or in at least a first facility, the Control Center in this latter case being responsible for coordinating said facilities, receiving the data from the analyses carried out in said facilities. Likewise, the location of the partial discharges and the decision-making for optimizing the maintenance of the distribution network is carried out in the Control Center.

The device for generating and injecting defined charge pulses comprises a coupling, which can be capacitive, and enables the connection of the aforementioned device in at least one second high voltage distribution facility, without involving the direct coupling on the distribution elements to be tested, such that the accessibility to the distribution element object of analysis, which is under voltage, is prevented.

This coupling comprises at least one input/output through which the connection with the distribution facility is carried out, said at least one input/output thus enabling both the tracking of the voltage of the distribution network and the injection of the defined charge pulse in a defined phase angle of the voltage waveform of the distribution network. The device for generating and injecting defined charge pulses comprises a synchronization circuit which is responsible for tracking the voltage of the distribution network of the same line phase where the generation and injection device is connected, and in addition, it determines in the voltage waveform the reference (zero crossing of the voltage of the network) with respect to which the injection of at least one defined charge pulse is carried out. The device also comprises an injection circuit equipped with a voltage waveform generator that enables the generation of a defined charge pulse for the subsequent injection thereof in the distribution network, in a phase angle of the voltage waveform of the network that is determined by the user.

The device for generating and injecting defined charge pulses is integrated, at least partially, in at least one coupling part that is connected to an active part of the distribution network under conditions of insulation and electric safety, such as for example in a second high voltage facility such as a power transformation substation or a distribution substation. In particular, the coupling part enables the generation and injection device to be connected to a high voltage cable or electrical equipment, maintaining the insulation and shielding characteristics of the assembly. In this regard, said coupling part mounted on a high voltage facility can be integrated, at least partially, in a separable connector or terminal. For this purpose, the coupling part consists of a sealed capsule that may comprise a first end connected by means of screwing to the separable connector by the free end of the latter, such as for example by the free end of a T-connector.

The device for generating and injecting defined charge pulses is single-phase, such that for each phase of the facility there is one device. In this way, a synchronization and independent injection for each phase line of the power distribution network is enabled. Likewise, it has been envisaged that the device can be actuated both locally and remotely, for example from a Remote Control Center.

### DESCRIPTION OF THE FIGURES

To complement the description and for the purpose of helping to make the characteristic of the invention more readily understandable, according to a preferred practical exemplary embodiment thereof, a set of figures is attached as an integral part of said description, which, by way of illustration and not limitation, represent the following:
Figure 1.- shows a diagram of a high voltage electric distribution network (2), wherein a possible arrangement of the set of elements comprising the system for monitoring partial discharges can be seen, among which are the measuring instruments (13, 14), the device for generating and injecting defined charge pulses (1), as well as the different facilities (3, 3', 3") where each of them are installed.
Figure 2.- shows a single-line diagram of the device for producing and injecting defined charge pulses (1), wherein the capacitive coupling (5), the synchronization circuit (10), the injection circuit (11) and the supply circuit (17) integrated inside the coupling part (8) are shown.
Figure 3.- shows a perspective view of the coupling part (8) wherein the device for generating and injecting defined charge pulses (1) is integrated.
Figure 4.- shows a perspective view of the installation of the device for generating and injecting defined charge pulses (1) in high voltage electrical equipment (18) of a distribution facility (3) according to the embodiment of figures 2 and 3.
Figure 5.- shows a single-line diagram of another possible embodiment of the device for generating and injecting defined charge pulses (1), wherein only the capacitive coupling (5) is integrated in the coupling part (8).
Figure 6.- shows a perspective view of the coupling part (8) according to the embodiment of figure 5, wherein part of the device for generating and injecting defined charge pulses (1) is integrated.
Figure 7.- shows a diagram of a high voltage electric distribution network (2), wherein the set of elements comprising the system for monitoring partial discharges can be seen, among which there are the measuring instruments (13, 14), the device for generating and injecting defined charge pulses (1), as well as the different facilities (3, 3', 3") wherein each of them are installed, and in this case the device (1) can be remotely operated from a Remote Control Center (16).
Figure 8.- shows a diagram of a high voltage electric distribution network (2), wherein the set of elements comprising the system for monitoring partial discharges can be seen, among which there are the measuring instruments (13, 14), the device for generating and injecting defined charge pulses (1), the zero crossing counter (20) incorporated inside the measuring instruments (13, 14), as well as the different facilities (3, 3', 3") wherein each of them are installed.

### DESCRIPTION OF THE INVENTION

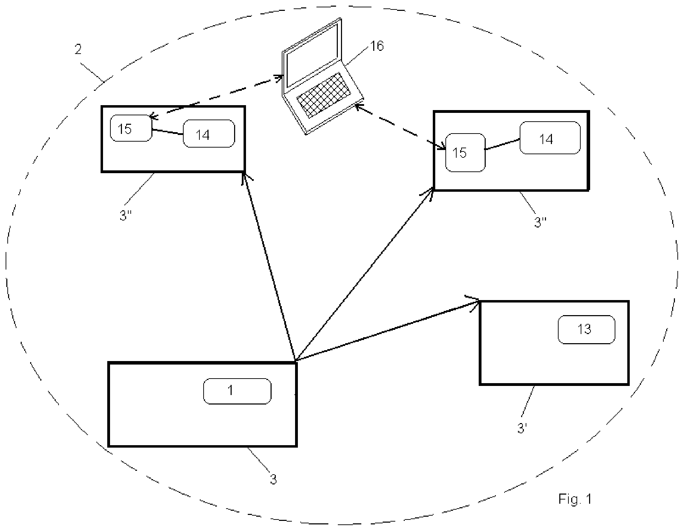

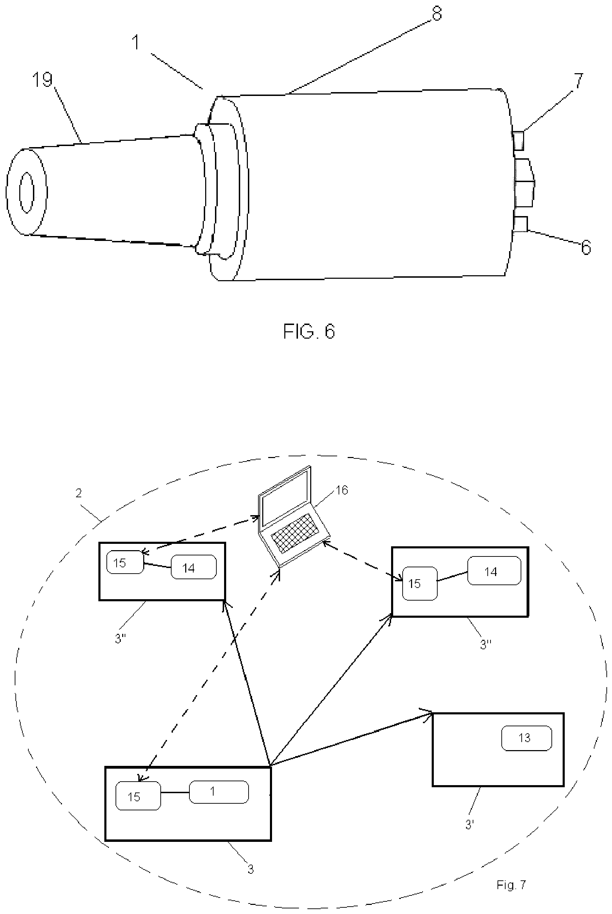

The following describes one implementation of the invention wherein the measuring instrument is located in a distribution network facility and the pulse generation and injection device in another facility separate from the first, although as noted previously, both can be placed in the same facility and there are also configurations that combine the two possibilities. The system for monitoring partial discharges in distribution elements under voltage (online or offline), such as for example cables, transformers, switches, electrical connections, etc., shown in figures 1 and 7, is applicable in high voltage electrical power distribution networks (2) comprising at least one high voltage electrical distribution facility (3, 3', 3"), such as for example a power transformation substation or a distribution substation, said facilities (3, 3', 3") comprising at least one high voltage electrical equipment (18), such as for example an electric cell. In at least a first facility (3', 3"), the monitoring system comprises at least one portable/stationary partial discharge measuring instrument (13, 14) and in at least a second facility (3) it comprises at least one device for generating and injecting defined charge pulses (1).

In this way, the monitoring system enables the quantification of the partial discharge measurements in distribution elements (4) through the measuring instruments (13, 14), as well as the synchronization of said instruments (13, 14). In a first step, the generation and injection device (1) tracks the voltage of the distribution network (2) determining the reference with respect to which the defined charge pulse is injected, and in a second step, by means of the generation and injection of a defined charge pulse and synchronized with the voltage of the network (2), the quantification of the partial discharge measurements through the measuring instruments (13, 14) regardless of the configuration or topology of the distribution network (2) is enabled, and in turn, the synchronization of the measuring instruments (13, 14) is enabled.

In this regard, in order to quantify the measurements, the monitoring system comprises a calibration step of at least one measuring instrument (13, 14) arranged in at least one first distribution facility (3', 3"), determining for this purpose a scale factor of the circuit for the, at least one, measuring instrument (13, 14) according to the configuration wherein the electric distribution network (2) is located. This scale factor enables the magnitude of at least one partial discharge to be quantified through the at least one measuring instrument (13, 14).

In turn, by means of the injection of defined charge pulses at different time intervals, in synchronization with the voltage waveform of the network and in a phase angle determined by the user, the monitoring system enables a step to be carried out that corresponds to the synchronization of at least two measuring instruments (13, 14), determining the moment in which said measuring instruments (13, 14), located in different locations, must start to measure the propagation times of the pulses between the generation point thereof and the measurement point, and/or aligning the clocks of the measuring instruments. In this way, the time differential between two measurement points is calculated for the subsequent calculation of the distance between the point where the partial discharge occurs and the point where the measurement is carried out (the point where the measuring instrument is installed).

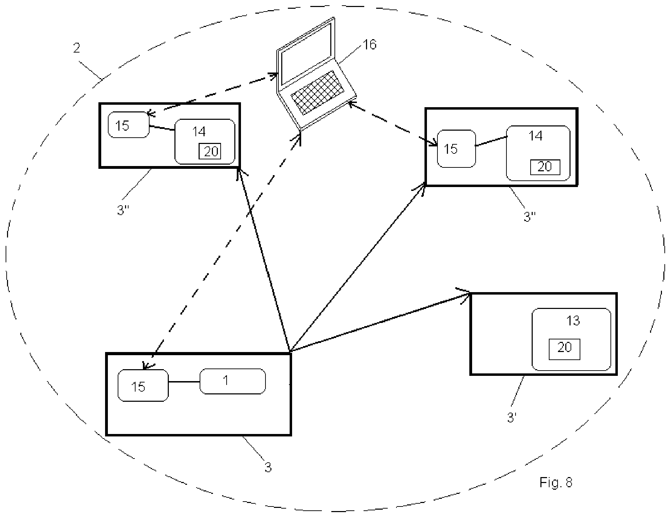

The synchronization of at least two measuring instruments (13, 14), that can be carried out from a Remote Control Center (16), as shown in figure 8, comprises a first step wherein, by means of at least one zero crossing counter (20) of the network voltage (2), the measurement starting time of at least one measuring instrument (13, 14) is adjusted to the measurement starting time of at least another measuring instrument (13, 14). The zero crossing counter (20) of the voltage of the network may be integrated inside the measuring instruments (13, 14).

Likewise, in a second synchronization step, the voltage waveform cycle of the network (2) of at least one measuring instrument (13, 14) is adjusted with the voltage waveform cycle of the network (2) of at least another measuring instrument (13, 14), using to do so the pulse itself generated for quantifying the discharges or said pulse and one or several additional defined charge pulses generated and injected by the device for producing and injecting defined charge pulses (1).

By means of a third synchronization step, the phase angle of the voltage waveform of the network (2) of at least one measuring instrument (13, 14) is adjusted with the phase angle of the voltage waveform of the network (2) of at least another measuring instrument (13, 14), using to do so the charge pulses.

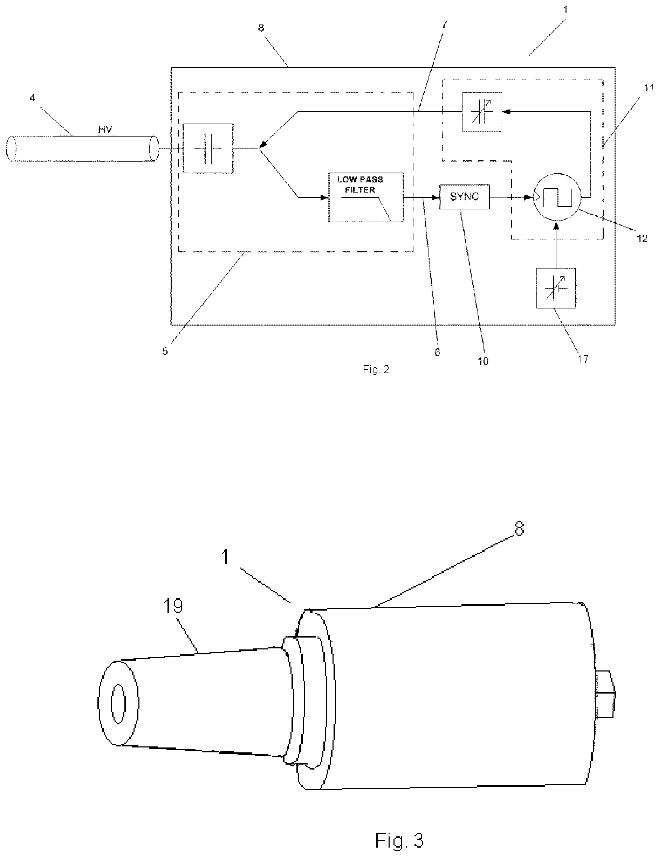

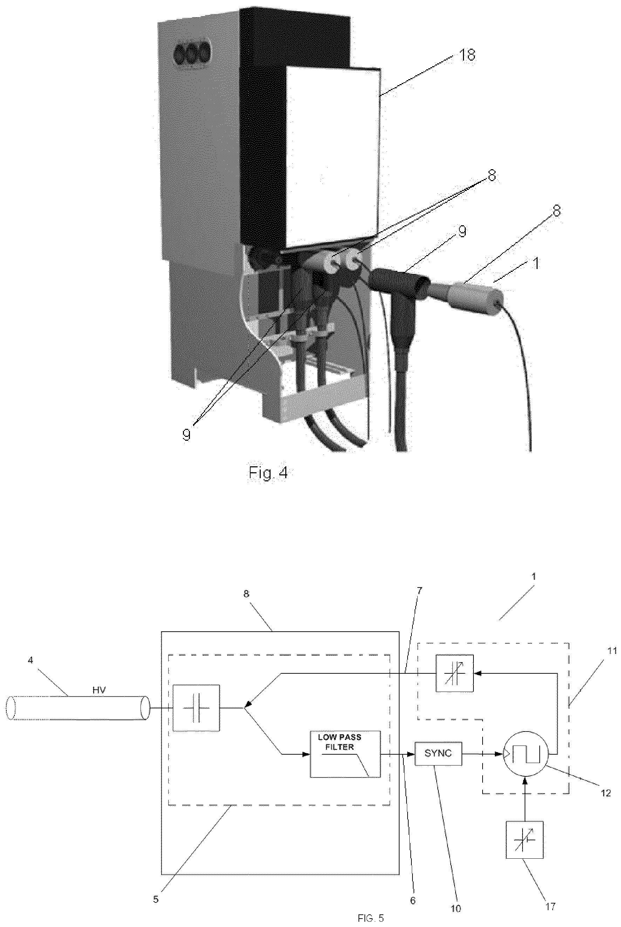

For this purpose, as shown in figures 2 and 5, the device (1) comprises a capacitive coupling (5), a synchronization circuit (10) and an injection circuit (11).

The capacitive coupling (5) comprises at least one input/output (6, 7), through which the device (1) tracks the voltage of the distribution network (2) and the subsequent injection of the defined charge pulse in a defined phase angle of the voltage waveform of the power distribution network (2).

Figures 2 and 5 show the synchronization circuit (10) which is responsible for tracking the voltage of the distribution network (2), and furthermore, determines in the voltage waveform the reference with respect to which the injection of the defined charge pulse is carried out. Moreover, it also shows the injection circuit (11) equipped with a voltage waveform generator (12) that enables a partial discharge-type pulse of a defined charge to be generated for subsequent injection in the distribution network (2), in a phase angle of the voltage waveform of the network (2) determined by the user, preventing the risk that the defined charge pulse can be injected in a phase angle of the voltage waveform comprising background noise, other partial discharges, etc.

The device for generating and injecting defined charge pulses (1) may be single phase, such that for each line phase of the facility (3) there can be one device (1), as shown in figure 4.

Figures 2 and 5 also show a power supply circuit (17) of the device (1), which may comprise at least one isolation transformer and a wave rectifier (not shown). However, the possibility that said device (1) can be powered via a power supply circuit (17) comprising at least one toroidal sensor and a wave rectifier (not shown) has also been envisaged.

Furthermore, the monitoring system also enables the partial discharges coming from insulation faults of the network (2) to be differentiated from other sources of partial discharges, locating (determining the distance between the point where the partial discharge occurs and the point where the measurement is carried out), identifying partial discharges, etc. In this regard, the signals captured by at least one measuring instrument (13, 14) are physically and mathematically processed through standard techniques. The system also enables the monitoring of the instantaneous voltage and current values and the effective values of the currents and voltages of each line phase, as well as the homopolar currents and voltages, energies, power, etc.

As shown in figure 1, the measuring instruments (13, 14) may be linked to communication means (15) that are installed in at least one first distribution facility (3', 3"), such that said communication means (15) are connected with a Remote Control Center (16), thus enabling both the monitoring of the high voltage distribution network (2) and the management of at least one first distribution facility (3', 3") to be carried out remotely. Figure 7 shows the possibility that the device for generating and injecting defined charge pulses (1) can be actuated from a Remote Control Center (16). In this regard, it has been envisaged that the device (1) may be linked to communication means (15) that are installed in at least one second facility (3), such that said means (15) are connected to a Remote Control Center (16) thus enabling the actuation of the device (1) to also be carried out remotely.

Therefore, the possibility that the execution of the different functions of the monitoring system can be carried out in the Control Center (16) or in at least one facility (3, 3', 3") wherein the measuring instruments (13, 14) and the device (1) are located has been envisaged.

Figures 2 to 6 show two exemplary embodiments of the device for generating and injecting defined charge (1) which is at least partially integrated in a coupling part (8) that connects to an active part of the distribution network (2), and in particular, according to a possible embodiment of the invention (figure 4), can be installed in a high voltage electrical equipment (18), said coupling part (8) being at least partially integrated in a separable connector or terminal (9) that is used for the connection of the high voltage cables, the coupling part (8) comprising an end (19) that enables the generation and injection device (1) to be coupled in the terminal (9) by means of screwing. In the example of figures 2 and 3, the capacitive coupling (5), the synchronization circuit (10), the injection circuit (11) and the power supply circuit (17) are integrated inside the coupling part (8); while in the example of figures 5 and 6, only the capacitive coupling (5) is integrated inside the coupling part (8), there being at least one input/output (6, 7) that is accessible on the exterior for the connection thereof to the synchronization circuit (10) and to the injection circuit (11).

In summary, the numeric references used in this text and indicated in the figures mentioned above represent the following components of the invention:
1.- Device for generating and injecting defined charge pulses
2.- Power distribution network
3, 3', 3".- Electrical energy distribution facility
4.- Electrical distribution element
5.- Capacitive coupling
6, 7.- Input/output of the capacitive coupling
8.- Coupling part
9.- Separable connector or terminal
10.- Synchronization circuit
11.- Injection circuit
12.- Voltage waveform generator
13, 14.- Partial discharge measuring instrument
15.- Communication means
16.- Remote Control Center
17.- Power supply circuit
18.- High voltage electrical equipment
19.- End of the coupling part
20.- Network voltage zero crossing counter

## Claims

1. Method for monitoring partial discharges in distribution elements (4) under voltage of a high voltage power distribution network (2) in service provided with said distribution elements (4), comprising the following steps: placing at least one measuring instrument (13, 14) and at least one device for generating and injecting defined charge pulses (1) in the network in service (2), wherein in a first step, without interrupting service in the network, the generation and injection device (1) tracks the voltage of the distribution network (2) determining the zero crossing of the voltage of the same line phase to which the generation and injection device is connected, with respect to which at least one defined charge pulse is injected by the generation and injection device, at different time intervals, and wherein in a second step, without interrupting service in the network the measurements of the partial discharges are quantified by the measuring instruments (13, 14) using the means of the generation and injection of a defined charge pulse which is synchronized with the voltage of the network (2).

2. Method according to claim 1, wherein the network is provided with different facilities (3, 3', 3") and at least one measuring instrument (13, 14) and a generation and injection device (1) are located in separate facilities.

3. Method according to claims 1 or 2, **characterized in that** when more than one measuring instrument (13, 14) is used, it comprises a synchronization step of said instruments (13, 14) using the generated charge pulse for the quantification of said pulse and one or several additional defined charge pulses generated and injected by the device (1).

4. Method according to claim 3, **characterized in that** the measuring instruments (13, 14) comprise at least one zero crossing counter (20) of the voltage of the network (2) that enables a first synchronization step to be carried out by adjusting the measurement starting time of at least one measuring instrument (13, 14) to the measurement starting time of at least another measuring instrument (13, 14).

5. Method according to claim 4, **characterized in that** it comprises a second synchronization step that adjusts the voltage waveform cycle of the network (2) of at least one measuring instrument (13, 14) with the voltage waveform cycle of the network (2) of at least another measuring instrument (13, 14), by using the charge pulse or pulses.

6. Method according to claim 5, **characterized in that** it comprises a third synchronization step that adjusts the phase angle of the voltage waveform of the network (2) of at least one measuring instrument (13, 14) with the phase angle of the voltage waveform of the network (2) of at least another measuring instrument (13, 14), by using the charge pulse or pulses.

7. Method according to any of the preceding claims, **characterized in that** it comprises a calibration step of the measuring instrument or instruments (13, 14) by means of determining the scale factor of the circuit according to the configuration of the distribution network (2).

8. Method according to claim 7, **characterized in that** the scale factor is determined by means of the injection of at least one defined charge pulse in a defined phase angle of the voltage waveform of the distribution network (2), at different time intervals, through the device (1).

9. Method according to claim 7, **characterized in that** determining the scale factor enables the quantification of the magnitude of at least one partial discharge through the at least one of the measuring instruments (13, 14).

10. Method according to any of the preceding claims, **characterized in that** at least one of the measuring instruments (13, 14) determines the distance between the point where the partial discharge occurs and the point where the measurement is carried out.

11. Method according to any of the preceding claims, **characterized in that** the signals captured by at least one measuring instrument (13, 14) are physically and mathematically processed to differentiate the partial discharges coming from insulation faults of the network (2) from other sources of partial discharge, and they are stored in a database.

12. Method according to any of claims 2-11, **characterized in that** the monitoring is carried out remotely by means of a Remote Control Center (16) connected to communication means (15) located in at least one of the facilities (3, 3', 3"), enabling the monitoring of the distribution network (2) to be carried out remotely.

13. Method according to claim 12, **characterized in that** the management of the facility or facilities (3, 3', 3") is also carried out through the Remote Control Center (16).

14. Method according to claim 13, **characterized in that** the partial discharges are identified in the Control Center (16) or in at least one facility (3', 3").

15. Method according to claims 13 or 14, **characterized in that** the location of partial discharges is carried out in the Control Center (16).

16. Method according to any of claims 13-15, **characterized in that** the decision-making is carried out in the Control Center (16).

17. Device for generating and injecting defined charge pulses (1) for carrying out the method according to any of the preceding claims, **characterized in that** the device (1) comprises a coupling (5) with at least one input/output (6, 7) and a synchronization circuit (10) for tracking the voltage of the distribution network (2) determining the reference with respect to which the pulse is injected at a phase angle determined by the user.

18. Device according to claim 17, **characterized in that** it comprises an injection circuit (11) comprising a waveform generator (12) that enables the generation of the defined charge pulse for the subsequent injection thereof in the distribution network (2).

19. Device according to any of claims 17-18, **characterized in that** it comprises a coupling part (8) adapted for allowing connection in at least one high voltage second distribution facility such that the accessibility to the distribution element object of analysis, which is under voltage, is prevented.

## Patentansprüche

1. Verfahren zum Überwachen von Teilentladungen in unter Spannung stehenden Verteilungselementen (4) eines Hochspannungsverteilungsnetzwerks (2) in Betrieb, das mit den Verteilungselementen (4) versehen ist, wobei das Verfahren folgende Schritte aufweist: Platzieren zumindest eines Messinstruments (13, 14) und zumindest einer Vorrichtung zum Erzeugen und Einbringen definierter Ladungspulse (1) in das Netzwerk in Betrieb (2), wobei in einem ersten Schritt, ohne Unterbrechung des Betriebs in dem Netzwerk, die Erzeugungs- und Einbringungsvorrichtung (1) die Spannung des Verteilungsnetzwerks (2) nachverfolgt, wobei der Nulldurchgang der Spannung derselben Leitungsphase, mit der die Erzeugungs- und Einbringungsvorrichtung verbunden ist, bestimmt wird, wobei im Bezug darauf zumindest ein definierter Ladungspuls durch die Erzeugungs- und Einbringungsvorrichtung eingebracht wird, zu unterschiedlichen Zeitintervallen, und wobei in einem zweiten Schritt, ohne Unterbrechung des Betriebs in dem Netzwerk, die Messungen der Teilentladungen durch die Messinstrumente (13, 14) unter Verwendung der Mittel zur Erzeugung und Einbringung eines definierten Ladungspulses, der mit der Spannung des Netzwerks (2) synchronisiert ist, quantifiziert werden.

2. Verfahren gemäß Anspruch 1, wobei das Netzwerk mit unterschiedlichen Einrichtungen (3, 3', 3") versehen ist und wobei zumindest ein Messinstrument (13, 14) und eine Erzeugungs- und Einbringungsvorrichtung (1) in getrennten Einrichtungen angeordnet sind.

3. Verfahren gemäß Anspruch 1 oder 2, **dadurch gekennzeichnet, dass** dann, wenn mehr als ein Messinstrument (13, 14) verwendet wird, das Verfahren einen Synchronisierungsschritt der Instrumente (13, 14) unter Verwendung des erzeugten Ladungspulses für die Quantifizierung des Pulses und eines oder mehrerer zusätzlicher definierter Ladungspulse, die durch die Vorrichtung (1) erzeugt und eingebracht werden, aufweist.

4. Verfahren gemäß Anspruch 3, **dadurch gekennzeichnet, dass** die Messinstrumente (13, 14) zumindest einen Nulldurchgangszähler (20) der Spannung des Netzwerks (2) aufweisen, der es ermöglicht, dass ein erster Synchronisierungsschritt durch Einstellen der Messstartzeit zumindest eines Messinstruments (13, 14) auf die Messstartzeit zumindest eines anderen Messinstruments (13, 14) ausgeführt wird.

5. Verfahren gemäß Anspruch 4, **dadurch gekennzeichnet, dass** das Verfahren einen zweiten Synchronisierungsschritt aufweist, der den Spannungswellenformzyklus des Netzwerks (2) zumindest eines Messinstruments (13, 14) mit dem Spannungswellenformzyklus des Netzwerks (2) zumindest eines weiteren Messinstruments (13, 14) durch die Verwendung des Ladungspulses oder der Ladungspulse einstellt.

6. Verfahren gemäß Anspruch 5, **dadurch gekennzeichnet, dass** das Verfahren einen dritten Synchronisationsschritt aufweist, der den Phasenwinkel der Spannungswellenform des Netzwerks (2) zumindest eines Messinstruments (13, 14) mit dem Phasenwinkel der Spannungswellenform des Netzwerks (2) zumindest eines weiteren Messinstruments (13, 14) durch die Verwendung des Ladungspulses oder Ladungspulse einstellt.

7. Verfahren gemäß einem der vorhergehenden Ansprüche, **dadurch gekennzeichnet, dass** das Verfahren einen Kalibrierungsschritt des Messinstruments oder der Messinstrumente (13, 14) durch Bestimmen des Skalierungsfaktors der Schaltung gemäß der Konfiguration des Verteilungsnetzwerks (2) aufweist.

8. Verfahren gemäß Anspruch 7, **dadurch gekennzeichnet, dass** der Skalierungsfaktor durch die Einbringung zumindest eines definierten Ladungspulses in einem definierten Phasenwinkel der Spannungswellenform des Verteilungsnetzwerks (2) zu unterschiedlichen Zeitintervallen durch die Vorrichtung (1) bestimmt wird.

9. Verfahren gemäß Anspruch 7, **dadurch gekennzeichnet, dass** das Bestimmen des Skalierungsfaktors die Quantifizierung der Größe zumindest einer Teilentladung durch das zumindest eine der Messinstrumente (13, 14) ermöglicht.

10. Verfahren gemäß einem der vorhergehenden Ansprüche, **dadurch gekennzeichnet, dass** zumindest eines der Messinstrumente (13, 14) den Abstand zwischen dem Punkt, an dem die Teilentladung auftritt, und dem Punkt, an dem die Messung ausgeführt wird, bestimmt.

11. Verfahren gemäß einem der vorhergehenden Ansprüche, **dadurch gekennzeichnet, dass** die Signale, die durch zumindest ein Messinstrument (13, 14) erfasst werden, physikalisch und mathematisch verarbeitet werden, um die Teilentladungen, die aus Isolierungsfehlern des Netzwerks (2) stammen, von anderen Teilentladungsquellen zu differenzieren, und diese in einer Datenbank gespeichert werden.

12. Verfahren gemäß einem der Ansprüche 2 bis 11, **dadurch gekennzeichnet, dass** die Überwachung durch ein Fernsteuerungszentrum (16) aus der Ferne ausgeführt wird, welches mit einer Kommunikationseinrichtung (15) verbunden ist, die sich in zumindest einer der Einrichtungen (3, 3', 3") befindet, wodurch ermöglicht wird, dass die Überwachung des Verteilungsnetzwerks (2) aus der Ferne ausgeführt wird.

13. Verfahren gemäß Anspruch 12, **dadurch gekennzeichnet, dass** die Verwaltung der Einrichtung oder der Einrichtungen (3, 3', 3") auch durch das Fernsteuerungszentrum (16) ausgeführt wird.

14. Verfahren gemäß Anspruch 13, **dadurch gekennzeichnet, dass** die Teilentladungen in dem Steuerungszentrum (16) oder in zumindest einer Einrichtung (3', 3") identifiziert werden.

15. Verfahren gemäß Anspruch 13 oder 14, **dadurch gekennzeichnet, dass** das Lokalisieren von Teilentladungen in dem Steuerungszentrum (16) ausgeführt wird.

16. Verfahren gemäß einem der Ansprüche 13 bis 15, **dadurch gekennzeichnet, dass** die Entscheidungstreffung in dem Steuerungszentrum (16) ausgeführt wird.

17. Vorrichtung zum Erzeugen und Einbringen definierter Ladungspulse (1) zum Ausführen des Verfahrens gemäß einem der vorhergehenden Ansprüche, **dadurch gekennzeichnet, dass** die Vorrichtung (1) eine Kopplung (5) mit zumindest einem Eingang/Ausgang (6, 7) und eine Synchronisationsschaltung (10) aufweist, um die Spannung des Verteilungsnetzwerks (2) nachzuverfolgen, wobei die Referenz bestimmt wird, in Bezug auf welche der Puls in einem durch den Benutzer bestimmten Phasenwinkel eingebracht wird.

18. Vorrichtung gemäß Anspruch 17, **dadurch gekennzeichnet, dass** die Vorrichtung eine Einbringungsschaltung (11) aufweist, die einen Wellenformgenerator (12) aufweist, der die Erzeugung des definierten Ladungspulses für die darauffolgende Einbringung davon in dem Verteilungsnetzwerk (2) ermöglicht.

19. Vorrichtung gemäß einem der Ansprüche 17 bis 18, **dadurch gekennzeichnet, dass** die Vorrichtung ein Kopplungsteil (8) aufweist, das dazu angepasst ist, eine Verbindung in zumindest einer zweiten Hochspannungsverteilungseinrichtung derart zu ermöglichen, dass der Zugang zu dem Verteilungselement-Analysegegenstand, der unter Spannung steht, verhindert wird.

## Revendications

1. Procédé de surveillance de décharges partielles dans des éléments de distribution (4) sous tension d'un réseau de distribution d'énergie à haute tension (2) en service pourvu desdits éléments de distribution (4), comprenant les étapes suivantes : la mise en place d'au moins un instrument de mesure (13, 14) et d'au moins un dispositif de génération et d'injection d'impulsions de charge définies (1) dans le réseau en service (2), dans lequel dans une première étape, sans interrompre le service dans le réseau, le dispositif de génération et d'injection (1) effectue le suivi de la tension du réseau de distribution (2) en déterminant le passage par le point zéro de la tension de la même phase de ligne à laquelle le dispositif de génération et d'injection est connecté, par rapport à laquelle au moins une impulsion de charge définie est injectée par le dispositif de génération et d'injection, à des intervalles de temps différents, et dans lequel dans une seconde étape, sans interrompre le service dans le réseau, les mesures des décharges partielles sont quantifiées par les instruments de mesure (13, 14) en utilisant le moyen de génération et d'injection d'une impulsion de charge définie qui est synchronisée avec la tension du réseau (2).

2. Procédé selon la revendication 1, dans lequel le réseau est pourvu de différentes installations (3, 3', 3") et au moins un instrument de mesure (13, 14) et un dispositif de génération et d'injection (1) sont situés dans des installations séparées.

3. Procédé selon les revendications 1 ou 2, **caractérisé en ce que** quand plus d'un instrument de mesure (13, 14) est utilisé, il comprend une étape de synchronisation desdits instruments (13, 14) en utilisant l'impulsion de charge générée pour la quantification de ladite impulsion et une ou plusieurs impulsions de charge définies supplémentaires générées et injectées par le dispositif (1).

4. Procédé selon la revendication 3, **caractérisé en ce que** les instruments de mesure (13, 14) comprennent au moins un compteur de passage par le point zéro (20) de la tension du réseau (2) qui permet à une première étape de synchronisation d'être réalisée en ajustant le temps de début de mesure d'au moins un instrument de mesure (13, 14) à l'instant de début de mesure d'au moins un autre instrument de mesure (13, 14) .

5. Procédé selon la revendication 4, **caractérisé en ce qu'**il comprend une deuxième étape de synchronisation qui ajuste le cycle de forme d'onde de tension du réseau (2) d'au moins un instrument de mesure (13, 14) avec le cycle de forme d'onde de tension du réseau (2) d'au moins un autre instrument de mesure (13, 14), en utilisant l'impulsion ou les impulsions de charge.

6. Procédé selon la revendication 5, **caractérisé en ce qu'**il comprend une troisième étape de synchronisation qui ajuste l'angle de phase de la forme d'onde de tension du réseau (2) d'au moins un instrument de mesure (13, 14) avec l'angle de phase de la forme d'onde de tension du réseau (2) d'au moins un autre instrument de mesure (13, 14), en utilisant l'impulsion ou les impulsions de charge.

7. Procédé selon l'une quelconque des revendications précédentes, **caractérisé en ce qu'**il comprend une étape d'étalonnage de l'instrument ou des instruments de mesure (13, 14) au moyen de la détermination du facteur d'échelle du circuit en fonction de la configuration du réseau de distribution (2).

8. Procédé selon la revendication 7, **caractérisé en ce que** le facteur d'échelle est déterminé au moyen de l'injection d'au moins une impulsion de charge définie dans un angle de phase défini de la forme d'onde de tension du réseau de distribution (2), à des intervalles de temps différents, par l'intermédiaire du dispositif (1).

9. Procédé selon la revendication 7, **caractérisé en ce que** la détermination du facteur d'échelle permet la quantification de l'amplitude d'au moins une décharge partielle à travers le au moins un des instruments de mesure (13, 14).

10. Procédé selon l'une quelconque des revendications précédentes, **caractérisé en ce qu'**au moins l'un des instruments de mesure (13, 14) détermine la distance entre le point où la décharge partielle se produit et le point où la mesure est effectuée.

11. Procédé selon l'une quelconque des revendications précédentes, **caractérisé en ce que** les signaux capturés par au moins un instrument de mesure (13, 14) sont traités physiquement et mathématiquement pour différencier les décharges partielles provenant de défauts d'isolation du réseau (2) des autres sources de décharge partielle, et ils sont stockés dans une base de données.

12. Procédé selon l'une quelconque des revendications 2 à 11, **caractérisé en ce que** la surveillance est effectuée à distance au moyen d'un centre de contrôle à distance (16) connecté à un moyen de communication (15) situé dans au moins l'une des installations (3, 3', 3"), ce qui permet d'effectuer à distance la surveillance du réseau de distribution (2).

13. Procédé selon la revendication 12, **caractérisé en ce que** la gestion de l'installation ou des installations (3, 3', 3") est également effectuée par l'intermédiaire du centre de contrôle à distance (16).

14. Procédé selon la revendication 13, **caractérisé en ce que** les décharges partielles sont identifiées dans le centre de contrôle (16) ou dans au moins une installation (3', 3").

15. Procédé selon les revendications 13 ou 14, **caractérisé en ce que** la localisation des décharges partielles est effectuée dans le centre de contrôle (16).

16. Procédé selon l'une quelconque des revendications 13 à 15, **caractérisé en ce que** la prise de décision est effectuée dans le centre de contrôle (16).

17. Dispositif de génération et d'injection d'impulsions de charge définies (1) pour mettre en œuvre le procédé selon l'une quelconque des revendications précédentes, **caractérisé en ce que** le dispositif (1) comprend un couplage (5) avec au moins une entrée/sortie (6, 7) et un circuit de synchronisation (10) pour effectuer le suivi de la tension du réseau de distribution (2) déterminant la référence par rapport à laquelle l'impulsion est injectée à un angle de phase déterminé par l'utilisateur.

18. Dispositif selon la revendication 17, **caractérisé en ce qu'**il comprend un circuit d'injection (11) comprenant un générateur de forme d'onde (12) qui permet la génération de l'impulsion de charge définie pour l'injection ultérieure de celle-ci dans le réseau de distribution (2).

19. Dispositif selon l'une quelconque des revendications 17 à 18, **caractérisé en ce qu'**il comprend une partie de couplage (8) adaptée pour permettre une connexion dans au moins une seconde installation de distribution à haute tension de sorte que l'accessibilité à l'élément de distribution objet de l'analyse, qui est sous tension, est empêchée.
